# EUROPEAN PATENT APPLICATION

(11) **EP 3 819 931 A1**
(43) Date of publication of application: **12.05.2021**
(21) Application number: 20203961.6
(22) Date of filing: 26.10.2020
(51) Int. Cl.: H01L 21/78, H01L 21/027, H01L 21/02, C09J 133/00

(54) **PROTECTIVE FILM FORMING AGENT, METHOD FOR PRODUCING SEMICONDUCTOR CHIP, AND METHOD FOR PRODUCING (METH)ACRYLIC RESIN**

(30) Priority: 08.11.2019 JP 2019203316
(71) Applicant: TOKYO OHKA KOGYO CO., LTD., Kawasaki-shi, Kanagawa 211 0012 (JP)
(72) Inventor: UEMATSU, Teruhiro, KANAGAWA, 211-0012 (JP)
(74) Representative: Plasseraud IP

(57) **Abstract**

To provide a protective film forming agent that is less likely to cause an excessive increase in viscosity when a solid content concentration thereof is raised, a method for producing a semiconductor chip using the protective film forming agent, and a method for producing a (meth)acrylic resin that can be preferably used as a component of the aforementioned protective film forming agent. In a protective film forming agent containing a water-soluble resin (A), light absorber (B) and solvent (S), a (meth)acrylic resin including a structural unit derived from a (meth)acrylamide derivative of a specific structure including an alicyclic structure is used as the water-soluble resin (A).

## Description

### BACKGROUND OF THE INVENTION

### Field of the Invention

The present invention relates to a protective film forming agent, a method for producing a semiconductor chip using the protective film forming agent, and a method for producing a (meth)acrylic resin that can be preferably used as a component of the aforementioned protective film forming agent.

### Related Art

A wafer formed in a semiconductor device manufacturing process has a laminate in which an insulating film and functional film are laminated on a surface of a semiconductor substrate such as silicon, and is demarcated by a lattice of scheduled division lines called streets. The respective regions demarcated by the streets define semiconductor chips such as IC and LSI.

A plurality of semiconductor chips are obtained by cutting the wafer along these streets. In addition, an optical device wafer has a laminate in which a gallium nitride-based compound semiconductor or the like is laminated, and is demarcated into a plurality of regions by the streets. By cutting along these streets, the optical device wafer is divided into optical devices such as light emitting diodes or laser diodes. These optical devices are widely applied to electronic equipment.

Such cutting along the streets of a wafer has been carried out in the past by a cutting device called a dicer. However, since a wafer having a laminate structure is a highly brittle material, this method has had a problem in that, upon cutting to divide the wafer into semiconductor chips or the like by a cutting blade (cutting edge), scratches or chipping occurs, causing the insulating film required as a circuit element formed on the chip surface to peel.

In order to avoid such flaws, the following method has been proposed (refer to Patent Document 1). Specifically, a mask containing a layer of water-soluble material is first formed on the surface of the semiconductor substrate. Next, a laser is irradiated on the mask to decompose and remove part of the mask, whereby the surface of the semiconductor substrate is exposed at parts of the mask. Subsequently, the semiconductor substrate exposed from the parts of the mask is cut by plasma etching to divide the semiconductor substrate into semiconductor chips (IC).

Patent Document 1: Japanese Unexamined Patent Application (Translation of PCT Application), Publication No. 2014-523112

### SUMMARY OF THE INVENTION

In the case of forming a protective film as a mask in the method described in Patent Document 1 or the like, it is preferable that the protective film can be formed by spray coating from the viewpoint of ease of formation of the protective film. With regard to the solid content concentration of a protective film forming agent used for forming the protective film, a higher concentration is more preferable since the higher concentration leads to a reduction in the number of coatings. However, when the solid content concentration of the protective film forming agent is raised, problems are posed in that the viscosity of the protective film forming agent is increased, and coating by a method such as spray coating is difficult.

The present invention has been made taking account of the above-mentioned problems, and has an object of providing a protective film forming agent that is less likely to cause an excessive increase in viscosity when the solid content concentration thereof is raised, a method for producing a semiconductor chip using the protective film forming agent, and a method for producing a (meth)acrylic resin that can be preferably used as a component of the aforementioned protective film forming agent.

The present inventors have found that the above-mentioned problems can be solved by using, in a protective film forming agent containing a water-soluble resin (A), a light absorber (B) and a solvent (S), a (meth)acrylic resin including a structural unit derived from a (meth)acrylamide derivative of a specific structure including an alicyclic structure as the water-soluble resin (A), thereby completing the present invention. More specifically, the present invention provides the following.

According to a first aspect of the present invention, in a protective film forming agent to be used for forming a protective film on the surface of a semiconductor wafer in dicing of the semiconductor wafer,
the protective film forming agent contains a water-soluble resin (A), a light absorber (B) and a solvent (S), in which the water-soluble resin (A) contains a (meth)acrylic resin including the structural unit derived from a (meth)acrylamide derivative represented by Formula (a1) below, 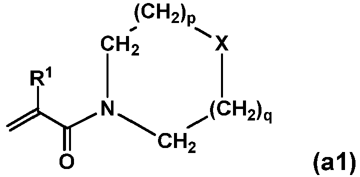 where R¹ is a hydrogen atom or a methyl group, X is a methylene group, -O-, -S-, or -NR²-, R² is a hydrogen atom or an alkyl group having 1 or more and 4 or less carbon atoms, p and q are each independently an integer of 0 or more and 6 or less, and the sum of p and q is 1 or more and 6 or less.

According to a second aspect of the present invention, a method for producing a semiconductor chip that processes a semiconductor wafer includes the steps of:
forming a protective film by coating the protective film forming agent as described in the first aspect on the semiconductor wafer; and
irradiating a laser beam on a predetermined position of at least one layer containing the protective film on the semiconductor wafer, a surface of the semiconductor wafer being exposed, and then forming a processed groove of a pattern according to a shape of the semiconductor chip.

According to a third aspect of the present invention, a method for producing a (meth)acrylic resin includes polymerizing a monomer containing a (meth)acrylamide derivative represented by Formula (a1) below in the presence of alkylene glycol monoacetate, 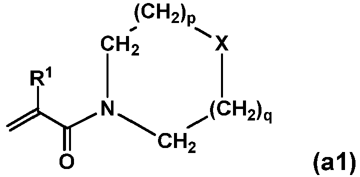 where R¹ is a hydrogen atom or a methyl group, X is a methylene group, -O-, -S-, or -NR²-, R² is a hydrogen atom or an alkyl group having 1 or more and 4 or less carbon atoms, p and q are each independently an integer of 0 or more and 6 or less, and the sum of p and q is 1 or more and 6 or less.

According to the present invention, it is possible to provide a protective film forming agent that is less likely to cause an excessive increase in viscosity when a solid content concentration thereof is raised, a method for producing a semiconductor chip using the protective film forming agent, and a method for producing a (meth)acrylic resin that can be preferably used as a component of the aforementioned protective film forming agent.

### BRIEF DESCRIPTION OF THE DRAWINGS

FIG. 1 is a perspective view showing a semiconductor wafer manufactured by a processing method of a wafer using the protective film forming agent of the present invention;
FIG. 2 is a cross-sectional enlarged view of the semiconductor wafer shown in FIG. 1;
FIG. 3 is an enlarged cross-sectional view of the main parts of a semiconductor wafer on which a protective film was formed;
FIG. 4 is a perspective view showing a state in which the semiconductor wafer on which the protective film was formed is supported by an annular frame via protective tape;
FIG. 5 is a perspective view of the main parts of a laser processing device which conducts laser irradiation processing;
FIG. 6 is a cross-sectional enlarged view of a semiconductor wafer including a protective film and a processed groove formed by laser beam irradiation;
FIG. 7 is an explanatory view showing plasma irradiation on the semiconductor wafer shown in FIG. 6;
FIG. 8 is a cross-sectional enlarged view showing a state of a semiconductor wafer being divided into semiconductor chips by plasma irradiation; and
FIG. 9 is a cross-sectional enlarged view showing a state in which a protective film on a semiconductor chip was removed.

### DETAILED DESCRIPTION OF THE INVENTION

### <<Protective Film Forming Agent>>

A protective film forming agent can be used in order to form a protective film on the surface of a semiconductor wafer in the dicing of a semiconductor wafer. The protective film forming agent contains a water-soluble resin (A), a light absorber (B) and a solvent (S). Hereinafter, the protective film forming agent is also noted as a "protective film forming agent".

More specifically, the protective film forming agent is preferably used in the formation of a protective film in the manufacturing method of semiconductor chips including: irradiating a laser beam on a protective film formed on a semiconductor wafer, the surface of the semiconductor wafer being exposed, and then forming a processed groove of a pattern according to the shape of the semiconductor chip; and irradiating laser or plasma on the semiconductor wafer including the above-mentioned protective film and the above-mentioned processed groove to process the position of the processed groove on the semiconductor wafer.

From the points of the removal of the protective film being easy by water washing after machining of the semiconductor wafer, and in the case of performing plasma irradiation in the manufacturing method of semiconductor chips described later, sufficient durability of the protective film against plasma irradiation, typically the film thickness of the protective film is preferably 1 µm or more and 100 µm or less, and more preferably 10 µm or more and 100 µm or less. 30 µm or more and 100 µm or less is even more preferable. In the case of irradiating a laser, the film thickness of the protective film is preferably 0.1 µm or more and 50 µm or less.

Hereinafter, components which are essentially and optionally contained by the protective film forming agent will be explained.

### <Water-soluble Resin (A)>

The water-soluble resin (A) is a substrate of the protective film formed using the protective film forming agent. The type of the water-soluble resin is not particular limited so long as being a resin which can form a film by dissolving in a solvent such as water, then coating and drying. Water-soluble refers to at least 0.5 g of the solute (water-soluble resin) dissolving in 100 g of water at 25°C.

The water-soluble resin (A) contains a (meth)acrylic resin including the structural unit derived from the (meth)acrylamide derivative represented by Formula (a1) below. It should be noted that, in the specification and claims of the present application, "(meth)acrylic" means both acrylic and methacrylic, "(meth)acrylate" means both acrylate and (meth)acrylate. 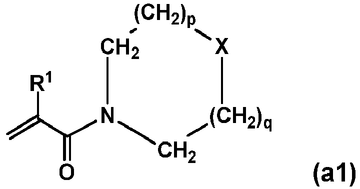 (in Formula (a1), R¹ is a hydrogen atom or a methyl group, X is a methylene group, -O-, -S-, or -NR²-, R² is a hydrogen atom or an alkyl group having 1 or more and 4 or less carbon atoms, p and q are each independently an integer of 0 or more and 6 or less, and the sum of p and q is 1 or more and 6 or less.)

Since the protective film forming agent contains, as the water-soluble resin (A), the (meth)acrylic resin including the structural unit derived from the (meth)acrylamide derivative represented by the above formula (a1), even when the solid content concentration of the protective film forming agent is set at a higher level, the viscosity of the protective film forming agent is less likely to be increased excessively. For this reason, spray coating of the protective film forming agent is easy regardless of the concentration of the protective film forming agent.

From the points of the access to and synthesis of the (meth)acrylamide derivative represented by Formula (a1) being easy, and the water solubility of the (meth)acrylic resin being favorable, in Formula (a1), it is preferable that p is 1 and q is 1. In other words, the cyclic group in Formula (a1) is preferably a 6-membered ring.

As described above, X in Formula (a1) is a methylene group, -O-, -S-, or -NR²-, and R² is a hydrogen atom or an alkyl group having 1 or more and 4 or less carbon atoms. From the points of the access to and synthesis of the (meth)acrylamide derivative represented by Formula (a1) being easy, the water solubility of the (meth)acrylic resin being favorable, X in Formula (a1) is preferably -O-.

Preferable specific examples of the (meth)acrylamide derivative represented by Formula (a1) include the following compounds.

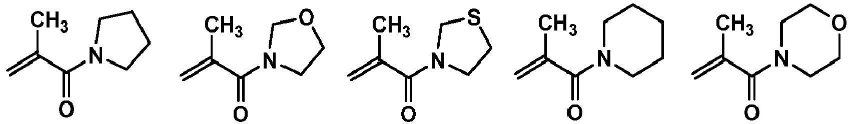

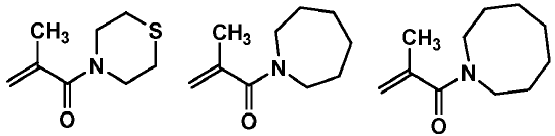

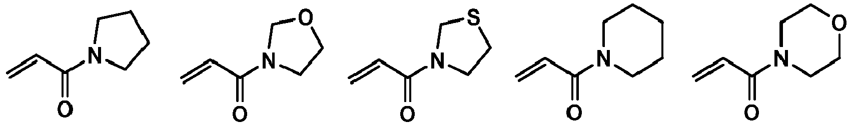

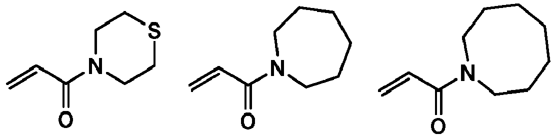

Among the compounds described above, the following compounds are preferable.

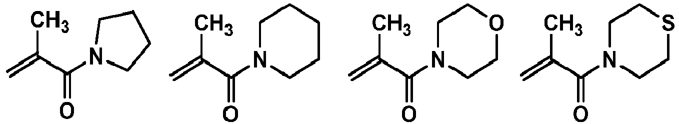

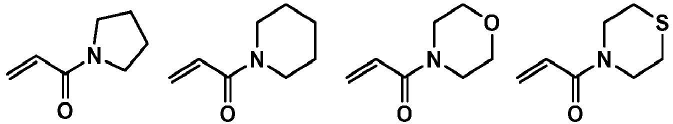

Among the compounds described above, the following compounds are more preferable.

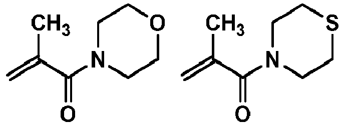

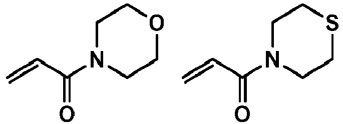

The ratio of the structural unit derived from the (meth)acrylamide derivative represented by Formula (a1) relative to the total structural units in the (meth)acrylic resin is preferably 70 mol% or more and 98 mol% or less. From the point of the ease in suppressing an increase in viscosity of the protective film forming agent in the case of blending the (meth)acrylic resin into the protective film forming agent at a high concentration, the ratio of the structural unit derived from the (meth)acrylamide derivative represented by Formula (a1) relative to the total structural units in the (meth)acrylic resin is more preferably 75 mol% or more and 95 mol% or less, and even more preferably 80 mol% or more and 90 mol% or less.

In the case of the (meth)acrylic resin being a copolymer of the (meth)acrylamide derivative represented by Formula (a1) and another monomer, a structural unit other than the structural unit derived from the (meth)acrylamide derivative represented by Formula (a1) in the (meth)acrylic resin is not particularly limited in a range not inhibiting the object of the present invention.

The other structural unit is not particularly limited in a range not inhibiting the object of the present invention. As an unsaturated compound that gives the other structural unit, an unsaturated carboxylic acid, a (meth)acrylic acid ester, a (meth)acrylamide other than the (meth)acrylamide derivative represented by Formula (a1), an allyl compound, vinyl ethers, vinyl esters, and styrenes are exemplified.

Examples of the unsaturated carboxylic acid include: (meth)acrylic acid; (meth)acrylic acid amide; crotonic acid; maleic acid, fumaric acid, citraconic acid, mesaconic acid, itaconic acid, and anhydrides of these dicarboxylic acids.

Examples of the (meth)acrylic acid ester include: straight or branched alkyl (meth)acrylates such as methyl (meth)acrylate, ethyl (meth)acrylate, propyl (meth)acrylate, amyl (meth)acrylate, and tert-octyl (meth)acrylate; chloroethyl (meth)acrylate, 2,2-dimethylhydroxypropyl (meth)acrylate, 2-hydroxyethyl (meth)acrylate, trimethylolpropane mono(meth)acrylate, benzyl (meth)acrylate, furfuryl (meth)acrylate; and (meth)acrylic acid esters having a group with an alicyclic skeleton.

In the (meth)acrylic acid esters having a group with an alicyclic skeleton, the alicyclic group constituting the alicyclic skeleton may be monocyclic or polycyclic. As the monocyclic alicyclic group, a cyclopentyl group, cyclohexyl group and the like can be exemplified. In addition, as the polycyclic alicyclic group, a norbornyl group, isobornyl group, tricyclononyl group, tricyclodecyl group, tetracyclododecyl group and the like can be exemplified.

Examples of the (meth)acrylamides include (meth)acrylamide, N-alkyl(meth)acrylamide, N-aryl(meth)acrylamide, N,N-dialkyl(meth)acrylamide, N,N-aryl(meth)acrylamide, N-methyl-N-phenyl(meth)acrylamide, N-hydroxyethyl-N-methyl(meth)acrylamide, and the like.

Examples of the allyl compound include: allyl esters such as allyl acetate, allyl caproate, allyl caprylate, allyl laurate, allyl palmitate, allyl stearate, allyl benzoate, allyl acetoacetate, and allyl lactate; allyloxyethanol; and the like.

Examples of the vinyl ethers include: aliphatic vinyl ethers such as hexyl vinyl ether, octyl vinyl ether, decyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether, and tetrahydrofurfuryl vinyl ether; vinyl aryl ethers such as vinyl phenyl ether, vinyl tolyl ether, vinyl chlorophenyl ether, vinyl 2,4-dichlorophenyl ether, vinyl naphthyl ether, and vinyl anthranyl ether; and the like.

Examples of the vinyl esters include vinyl butyrate, vinyl isobutyrate, vinyl trimethylacetate, vinyl diethylacetate, vinyl valerate, vinyl caproate, vinyl chloroacetate, vinyl dichloroacetate, vinyl methoxyacetate, vinyl butoxyacetate, vinyl phenylacetate, vinyl acetoacetate, vinyl lactate, vinyl β-phenylbutyrate, vinyl benzoate, vinyl salicylate, vinyl chlorobenzoate, vinyl tetrachlorobenzoate, vinyl naphthoate, and the like.

Examples of the styrenes include: styrene; alkylstyrenes such as methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene, and acetoxymethylstyrene; alkoxystyrenes such as methoxystyrene, 4-methoxy-3-methylstyrene, and dimethoxystyrene; halostyrenes such as chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, and 4-fluoro-3-trifluoromethylstyrene; and the like.

As the other structural unit, from the points of the unlikelihood of a decline in the water solubility of the (meth)acrylic resin, and the ease in suppressing the occurrence of cracks in the protective film, a structural unit being soluble in water and having low Tg is preferable. From the viewpoint described above, a structural unit derived from a (meth)acrylic acid ester represented by the following Formula (a2) is preferable as the other structural unit.

CH₂=CR¹-CO-O-(-R³-O-)ᵣ-R⁴ ... (a2)

(in Formula (a2), R¹ is a hydrogen atom or a methyl group, R³ is an alkylene group having 1 or more and 4 or less carbon atoms, R⁴ is a hydrogen atom or an alkyl group having 1 or more and 4 or less carbon atoms, r is an integer of 1 or more and 6 or less, and when r is an integer of 2 or more and 6 or less, a plurality of R³ groups may be identical to or different from one another.)

In Formula (a2), R³ is an alkylene group having 1 or more and 4 or less carbon atoms. Specific examples of the alkylene group represented by R³ include -CH₂-, -CH₂CH₂-, -CH (CH₃) CH₂-, and -CH₂CH₂CH₂CH₂-. As the alkylene group represented by R³, - CH₂CH₂-, and -CH(CH₃)CH₂- are preferable.

In Formula (a2), R⁴ is a hydrogen atom, or an alkyl group having 1 or more and 4 or less carbon atoms. Examples of the alkyl group represented by R⁴ include a methyl group, ethyl group, n-propyl group, isopropyl group, n-butyl group, isobutyl group, sec-butyl group, and tert-butyl group. As R⁴, a hydrogen atom, a methyl group, and an ethyl group are preferable.

In Formula (a2), r is an integer of 1 or more and 6 or less, and preferably 1, 2, or 3.

Preferable examples of the (meth)acrylic acid ester represented by Formula (a2) include the following compounds. In the following formulas, r is an integer of 1 or more and 6 or less, and preferably 1, 2, or 3.

CH₂=CH-CO-O-(-CH₂CH₂-O-)ᵣ-H

CH₂=C(CH₃)-CO-O-(-CH₂CH₂-O-)ᵣ-H

CH₂=CH-CO-O-(-CH₂CH₂-O-)ᵣ-CH₃

CH₂=C(CH₃)-CO-O-(-CH₂CH₂-O-)ᵣ-CH₃

CH₂=CH-CO-O-(-CH₂CH₂-O-)ᵣ-CH₂CH₃

CH₂=C(CH₃)-CO-O-(-CH₂CH₂-O-)ᵣ-CH₂CH₃

CH₂=CH-CO-O-(-CH(CH₃)CH₂-O-)ᵣ-H

CH₂=C(CH₃)-CO-O-(-CH(CH₃)CH₂-O-)ᵣ-H

CH₂=CH-CO-O-(-CH(CH₃)CH₂-O-)ᵣ-CH₃

CH₂=C(CH₃)-CO-O-(-CH(CH₃)CH₂-O-)ᵣ-CH₃

CH₂=CH-CO-O-(-CH(CH₃)CH₂-O-)ᵣ-CH₂CH₃

CH₂=C(CH₃)-CO-O-(-CH(CH₃)CH₂-O-)ᵣ-CH₂CH₃

CH₂=CH-CO-O-(-CH₂CH(CH₃)-O-)ᵣ-H

CH₂=C(CH₃)-CO-O-(-CH₂CH(CH₃)-O-)ᵣ-H

CH₂=CH-CO-O-(-CH₂CH(CH₃)-O-)ᵣ-CH₃

CH₂=C(CH₃)-CO-O-(-CH₂CH(CH₃)-O-)ᵣ-CH₃

CH₂=CH-CO-O-(-CH₂CH(CH₃)-O-)ᵣ-CH₂CH₃

CH₂=C(CH₃)-CO-O-(-CH₂CH(CH₃)-O-)ᵣ-CH₂CH₃

The ratio of the structural unit derived from the (meth)acrylic acid ester represented by Formula (a2) relative to the total structural units in the (meth)acrylic resin including the structural unit derived from the (meth)acrylamide derivative represented by Formula (a1) is preferably 8 mol% or more and 20 mol% or less, and more preferably 10 mol% or more and 18 mol% or less from the viewpoint of the ease in suppressing the occurrence of cracks in the protective film.

From the viewpoint of a balance of degradability upon irradiation with a laser beam, and the film forming property, the weight average molecular weight of the (meth)acrylic resin including the structural unit derived from the (meth)acrylamide derivative represented by Formula (a1) is preferably 1,000 or more and 100,000 or less, more preferably 3,000 or more and 50,000 or less, and even more preferably 5,000 or more and 15,000 or less. Also for the water-soluble resin (A) other than the (meth)acrylic resin including the structural unit derived from the (meth)acrylamide derivative represented by Formula (a1), the weight average molecular weight falling within the above-mentioned range is preferable. In the case of the water-soluble resin (A) being a mixture of a plurality of types of resins, it is preferable that the weight average molecular weight of each resin constituting the water-soluble resin (A) falls within the above-mentioned range.

The (meth)acrylic resin including the structural unit derived from the (meth)acrylamide derivative represented by Formula (a1) is preferably produced by conducting polymerization in the presence of a chain transfer agent. The chain transfer agent is not particularly limited, but is preferably a mercapto compound.

Examples of the mercapto compound include: mercaptoalcohols such as 2-mercaptoethanol, 1,3-mercaptopropanol, and thioglycerol; mercaptocarboxylic acids such as 3-mercaptopropionic acid, mercaptosuccinic acid, and mercaptoacetic acid; salts of the mercaptocarboxylic acids described above; ethyl 2-mercaptoacetate; cysteine; n-dodecyl mercaptan, and the like. Among these, mercaptoalcohols are preferable.

The amount used of the chain transfer agent is not particularly limited in a range not inhibiting the object of the present invention. Typically, a ratio of the number of moles of the chain transfer agent relative to the number of moles of the total structural units in the (meth)acrylic resin including the structural unit derived from the (meth)acrylamide derivative represented by Formula (a1) is preferably 0.01 mol% or more, more preferably 0.05 mol% or more and 5 mol% or less, and even more preferably 0.1 mol% or more and 3 mol% or less.

A method for producing the (meth)acrylic resin including the structural unit derived from the (meth)acrylamide derivative represented by Formula (a1) is not particularly limited. Well-known methods for producing a (meth)acrylic resin may be employed as appropriate.

The (meth)acrylic resin including the structural unit derived from the (meth)acrylamide derivative represented by Formula (a1) is usually produced using a method in which monomer(s) of the desired type and composition is/are polymerized in the presence of a polymerization initiator.

The type of the polymerization initiator is not particularly limited so long as the polymerization proceeds favorably. Preferable specific examples of the polymerization initiator include radical polymerization initiators e.g., azo-based polymerization initiators such as 2,2'-azobisisobutyronitrile, 2,2'-azobis(2-methylpropionamidine) dihydrochloride, dimethyl 2,2'-azobisisobutyrate, and 4,4'-azobis(4-cyanovaleric acid); peroxides such as benzoyl peroxide and hydrogen peroxide; cationic polymerization initiators such as boron trifluoride or complexes thereof, iron(II) chloride, diethylaluminum chloride, diethylzinc, heteropolyacids and activated clay; and the like.

Among these, azo-based polymerization initiators are preferable from the point of the polymerization efficiency. The polymerization initiator can be used independently as one type, or can be used by combining two or more types.

The amount used of the polymerization initiator is not particularly limited so long as the polymerization proceeds favorably. The ratio of the number of moles of the polymerization initiator relative to the number of moles of the total structural units in the (meth)acrylic resin including the structural unit derived from the (meth)acrylamide derivative represented by Formula (a1) is more preferably 0.1 mol or more and 10 mol or less, and even more preferably 3 mol or more and 7 mol or less.

The (meth)acrylic resin including the structural unit derived from the (meth)acrylamide derivative represented by Formula (a1) is preferably produced by polymerizing the monomer(s) in the presence of a solvent. The solvent is not particularly limited so long as the polymerization proceeds favorably. From the point of the ability to produce a (meth)acrylic resin which gives a protective film forming agent that is likely to suppress the occurrence of cracks in the protective film, it is preferable that the monomer(s) is/are polymerized in the presence of one or more types selected from the group consisting of alkylene glycol monoalkyl ether, alkylene glycol monoacetate, and alkylene glycol monoalkyl ether monoacetate.

The ratio of the mass of one or more selected from the group consisting of alkylene glycol monoalkyl ether, alkylene glycol monoacetate, and alkylene glycol monoalkyl ether monoacetate relative to the total mass of the solvent used in the polymerization is preferably 50% by mass or more, more preferably 70% by mass or more, even more preferably 80% by mass or more, even more preferably 90% by mass or more, particularly preferably 95% by mass or more, and most preferably 100% by mass.

As the alkylene glycol monoalkyl ether, monomethyl ether, monoethyl ether, mono-n-propyl ether, or mono-n-butyl ether of alkylene glycol having 2 or more and 4 or less carbon atoms are preferable. Specific examples of the alkylene glycol monoalkyl ether include ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether, propylene glycol mono-n-propyl ether, and propylene glycol mono-n-butyl ether.

As the alkylene glycol monoacetate, monoacetates of alkylene glycol having 2 or more and 4 or less carbon atoms are preferable. Specific examples of the alkylene glycol monoacetate include ethylene glycol monoacetate, and propylene glycol monoacetate.

As the alkylene glycol monoalkyl ether acetate, monomethyl ether acetate, monoethyl ether acetate, mono-n-propyl ether acetate, or mono-n-butyl ether acetate of alkylene glycol having 2 or more and 4 or less carbon atoms is preferable. Specific examples of the alkylene glycol monoalkyl ether acetate include ethylene glycol monomethyl ether acetate, ethylene glycol monoethyl ether acetate, ethylene glycol mono-n-propyl ether acetate, ethylene glycol mono-n-butyl ether acetate, propylene glycol monomethyl ether acetate, propylene glycol monoethyl ether acetate, propylene glycol mono-n-propyl ether acetate, and propylene glycol mono-n-butyl ether acetate.

Among the solvents selected from the group consisting of the alkylene glycol monoalkyl ether, the alkylene glycol monoacetate, and the alkylene glycol monoalkyl ether monoacetate, from the point of ease in achieving the desired effects through the use thereof, propylene glycol monomethyl ether is preferable.

In the polymerization reaction, various additives that have been conventionally used in polymerization reactions can be used together with the polymerization initiator, as needed. As such an additive, a catalytic promoter, a pH adjusting agent and a buffering agent and the like can be exemplified.

The polymerization temperature and the polymerization time in the production of the (meth)acrylic resin including the structural unit derived from the (meth)acrylamide derivative represented by Formula (a1) are not particularly limited. The polymerization temperature and the polymerization time are determined as appropriate in consideration of the type of the polymerization initiator, an average molecular weight of the obtained (meth)acrylic resin, a production efficiency of the (meth)acrylic resin and a production cost, and the like.

The protective film forming agent may contain, as the water-soluble resin (A), a water-soluble resin other than the (meth)acrylic resin including the structural unit derived from the (meth)acrylamide derivative represented by Formula (a1) together with the (meth)acrylic resin in a range not inhibiting the object of the present invention.

As specific examples of the other water-soluble resin (A), it is possible to exemplify a vinyl resin, cellulose resin, polyethylene oxide, polyglycerin, water-soluble nylon, etc. The vinyl resin is not particularly limited, so long as being a homopolymer or copolymer of monomers having a vinyl group, and being a water-soluble resin. As the vinyl resin, a polyvinyl alcohol, polyvinyl acetal (including vinyl acetate copolymers), polyvinylpyrrolidone, polyacrylamide, poly(N-alkylacrylamide), polyallylamine, poly(N-alkylallylamine), partially amidated polyallylamine, poly(diallylamine), allylamine-diallylamine copolymer, polyacrylic acid, polyvinyl alcohol polyacrylate block copolymer, and polyvinyl alcohol polyacrylate ester block copolymer can be exemplified. The cellulose resin is not particularly limited so long as being a water-soluble cellulose derivative. As the cellulose resin, methyl cellulose, ethyl cellulose, hydroxypropyl cellulose, etc. can be exemplified. These can be used independently as one type, or can be used by combining two or more types.

Among the above-mentioned specific examples of the other water-soluble resin, due to shape deterioration, etc. of the processed groove by heat sagging of the protective film hardly occurring, a vinyl resin and cellulose resin are preferable, and polyvinylpyrrolidone and hydroxypropyl cellulose are more preferable.

The protective film formed on the semiconductor wafer surface normally is removed from the surface of the semiconductor wafer or semiconductor chip, at the appropriate moment after formation of the processed groove, according to the method of processing a semiconductor wafer including the protective film and processed groove into semiconductor chips. For this reason, a water-soluble resin having low affinity with the semiconductor wafer surface is preferable as the other water-soluble resin from the point of water washability of the protective film. As the other water-soluble resin having low affinity with the semiconductor wafer surface, a resin having only an ether linkage, hydroxyl group, or amide bond as polar groups, for example, polyvinyl alcohol, polyethylene glycol, polyvinyl pyrrolidine, and hydroxypropyl cellulose, are preferable.

From the viewpoint of the spray coating of the protective film forming agent being easy regardless of the solid content concentration of the protective film forming agent, in the case of preparing an aqueous solution of the water-soluble resin (A) with a solid content concentration of 30% by mass, the viscosity of the aqueous solution is preferably 100 cp or less, more preferably 60 cp or less, and even more preferably 50 cp or less. In addition, in the case of preparing a propylene glycol monomethyl ether solution of the water-soluble resin (A) with a solid content concentration 30% by mass, the viscosity of the solution is preferably 100 cp or less, more preferably 60 cp or less, and even more preferably 50 cp or less. Herein, the viscosities of the solutions are viscosity as measured at 25°C using a rotational viscometer (E-type; cone and plate type).

From the point of the ease in setting the viscosity of an aqueous solution of the water-soluble resin (A) with a solid content concentration of 30% by mass within the above-mentioned range, the content of the (meth)acrylic resin including the structural unit derived from the (meth)acrylamide derivative represented by Formula (a1) in the water-soluble resin (A) is preferably 50% by mass or more, more preferably 70% by mass or more, even more preferably 80% by mass or more, even more preferably 90% by mass or more, particularly preferably 95% by mass or more, and most preferably 100% by mass.

The water-soluble resin (A) is preferably a resin which exhibits a weight loss rate of 80 % by weight or more in the case of heating up to 500°C in thermogravimetry in an air atmosphere. The weight loss rate in the case of heating up to 500°C is more preferably 90 % by weight or more, and even more preferably 95 % by weight or more. In the case of using a protective film forming agent containing a water-soluble resin (A) for which the weight loss rate when heating up to 500°C is within the above-mentioned range, since decomposition of the water-soluble resin (A) favorably progresses from the energy of the laser beam in the protective film, a processed groove that is favorably opened in the protective film tends to form by the irradiation of a laser beam.

The thermogravimetry for obtaining the weight loss rate can be performed in accordance with a common thermogravimetry method.

The method for adjusting the weight loss rate of the water-soluble resin (A) is not particularly limited. Generally, so long as being the same type of resin, the weight loss rate of the water-soluble resin (A) will be higher with a smaller average molecular weight.

Since opening defects upon forming the processed groove by irradiating a laser beam on the protective film, shape deterioration of the processed groove due to heat sagging of the protective film, etc. hardly occur, the ratio of the mass of water-soluble resin (A) relative to the total amount of the mass of water-soluble resin (A) and mass of light absorber (B) in the protective film forming agent is preferably 60% by mass or more and 99% by mass or less, and more preferably 80% by mass or more and 95% by mass or less.

### <Light Absorber (B)>

The protective film forming agent contains a light absorber (B) with the purpose of efficiently absorbing the energy of the laser beam in the protective film, and promoting the thermal decomposition of the protective film.

As the light absorber (B), for example, it is possible to use a water-soluble dye, water soluble pigment, water-soluble ultraviolet absorber, etc. These are all water soluble, and are advantageous for uniform presence in the protective film. In the case of using a water-soluble light absorber, the storage stability of the protective film forming agent is high, and since flaws such as phase separation of the protective film forming agent and precipitation of the light absorber will not be induced during storage of the protective film forming agent, it is advantageous also in the point of tending to maintain a favorable coatability of the protective film forming agent for a long period.

It should be noted that a water insoluble light absorber such as a colorant can also be used. In the case of using a water-insoluble light absorber, although fatal obstacles to use of the protective film forming agent will not arise, variation in the laser absorptivity of the protective film may arise, it may be difficult to obtain a protective film forming agent that excels in storage stability and coatability, and it may be difficult to form a protective film of uniform thickness.

As specific examples of the water-soluble dye, a water-soluble dye is selected from among azo dyes (monoazo and polyazo dyes, metal complex azo dyes, pyrazolone azo dyes, stilbene azo dyes, thiazole azo dyes), anthraquinone dyes (anthraquinone derivatives, anthrone derivatives), indigoid dyes (indigoid derivatives, thioindigoid derivatives), phthalocyanine dyes, carbonium dyes (diphenylmethane dyes, triphenylmethane dyes, xanthene dyes, acridine dyes), quinone imine dyes (azine dyes, oxazine dyes, thiazine dyes), methine dyes (cyanine dyes, azomethine dyes), quinoline dyes, nitroso dyes, benzoquinone and naphthoquinone dyes, naphthalimide dyes, perinone dyes and other dyes.

As the water-soluble pigment, for example, pigments for food additives such as Food Red No. 2, Food Red No. 40, Food Red No. 102, Food Red No. 104, Food Red No. 105, Food Red No. 106, Food Yellow NY, Food Yellow No. 4 tartrazine, Food Yellow No. 5, Food Yellow No. 5 Sunset Yellow FCF, Food Orange AM, Food Vermillion No. 1, Food Vermillion No. 4, Food Vermillion No. 101, Food Blue No. 1, Food Blue No. 2, Food Green No. 3, Food Melon Color B, and Food Egg Color No. 3 are preferred from the viewpoint of low environmental load, etc.

As the water-soluble ultraviolet absorber, for example, it is possible to exemplify organic acids such as 4,4'-dicarboxybenzophenone, benzophenone-4-carboxylic acid, 2-carboxyanthraquinone, 1,2-naphthalenedicarboxylic acid, 1,8-naphthalenedicarboxylic acid, 2,3-naphthalenedicarboxylic acid, 2,6-naphthalenedicarboxylic acid, and 2,7-naphthalenedicarboxylic acid, 4-aminocinnamic acid, 3-aminocinnamic acid, 2-aminocinnamic acid, sinapic acid (3,5-dimethoxy-4-hydroxycinnamic acid), ferulic acid, caffeine acid, biphenyl-4-sulfonic acid, 2,6-anthraquinone disulfonic acid, 2,7-anthraquinone disulfonic acid, curcumin and tetrahydroxybenzophenone; sodium salt, potassium salt, ammonium salt, and quaternary ammonium salt of these organic acids; and water-soluble amines such as EAB-F(4,4'-bis(diethylamino)benzophenone. Among these, 4-aminocinnamic acid, 3-aminocinnamic acid, 2-aminocinnamic acid and ferulic acid are preferable, 4-aminocinnamic acid and ferulic acid are more preferable, and 4-aminocinnamic acid is particularly preferable.

As the light absorber (B), a compound represented by the following Formula (B1) is particularly preferable. 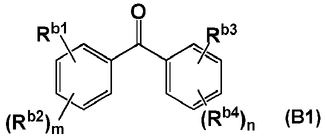 (in Formula (B1), R^{b1} and R^{b3} are each independently a hydroxyl group or carboxy group, R^{b2} and R^{b4} are each independently a hydroxyl group, carboxy group or group represented by -NR^{b5}R^{b6}, R^{b5} and R^{b6} are each independently a hydrogen atom or alkyl group having 1 or more and 4 or less carbon atoms, and m and n are each independently an integer of 0 or more and 2 or less.)

The compound represented by the above Formula (B1) has a high absorbance index, and exhibits a high absorbance index even in the case of adding to the protective film forming agent together with an alkali. For this reason, when forming a protective film using the protective film forming agent containing a compound represented by the above Formula (B1) as the light absorber (B), it is possible to favorably perform partial decomposition by laser of the protective film upon mask formation for dicing.

In the above Formula (B1), R^{b2} and R^{b4} may be a group represented by -NR^{b5}R^{b6}. R^{b5} and R^{b6} are each independently a hydrogen atom or an alkyl group having 1 or more and 4 or less carbon atoms. The alkyl group as R^{b5} and R^{b6} may be a straight chain or a branched chain. Specific examples of the alkyl group as R^{b5} and R^{b6} include a methyl group, ethyl group, n-propyl group, isopropyl group, n-butyl group, isobutyl group, sec-butyl group and tert-butyl group.

As the group represented by -NR^{b5}R^{b6}, an amino group, methylamino group, ethylamino group, dimethylamino group and diethylamino group are preferable, and an amino group, dimethylamino group and diethylamino group are more preferable.

The compound represented by Formula (B1) is preferably a compound represented by the following Formula (B1-1) due to the height of absorbance index under the presence or absence of a base: 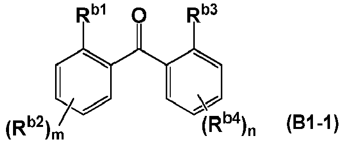 (in Formula (B1-1), R^{b1} to R^{b4}, m and n are the same as those in Formula (B1)).

Based on the height of the absorbance index under the presence or absence of a base, it is preferable for at least one of R^{b1} and R^{b3} to be a hydroxyl group in the above Formula (B1) and Formula (B1-1).

The compound represented by Formula (B1-1) is preferably a compound represented by any of the following Formulas (B1-1a) to (B1-1e): 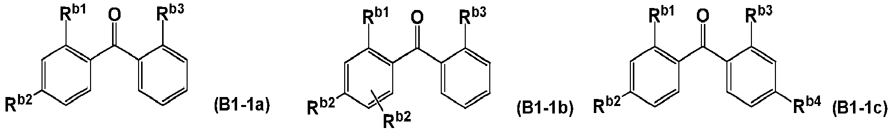 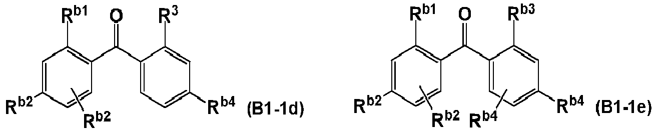 (in Formula (B1-1a) to Formula (B1-1e), R^{b1} to R^{b4} are the same as those in Formula (B1)).

Among the compounds represented by Formula (B1-1a) to Formula (B1-1e), compounds represented by Formula (B1-1a) are preferred. In the compounds represented by Formula (B1-1a) to Formula (B1-1e), it is preferable for R^{b2} to be the aforementioned group represented by -NR^{b5}R^{b6}, and R^{b5} and R^{b6} to each independently be alkyl groups having 1 or more and 4 or less carbon atoms.

As preferable specific examples of compounds represented by Formula (B1), the following compounds can be exemplified.

Among these compounds, the compounds described below are preferable due to ease of availability, and exhibiting a high absorbance index even under the presence of a base.

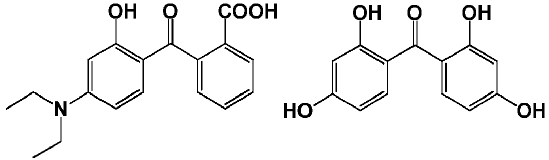

In the case of light absorber (B) containing the compound represented by Formula (B1), the proportion of the mass of the compound represented by Formula (B1) relative to the mass of light absorber (B) is not particularly limited in a range not inhibiting the object of the present invention. The proportion of the mass of the compound represented by Formula (B1) relative to the mass of light absorber (B) is preferably 70% by mass or more, more preferably 80% by mass or more, even more preferably 95% by mass or more, and particularly preferably 100% by mass.

The content of light absorber (B) in the protective film forming agent is not particularly limited in a range not inhibiting the object of the present invention. The content of light absorber (B) in the protective film forming agent is preferably 0.1% by mass or more and 10% by mass or less. Since opening defects upon forming the processed groove by irradiating a laser beam on the protective film, shape deterioration of the processed groove due to heat sagging of the protective film, etc. hardly occur, the ratio of the mass of light absorber (B) relative to the total amount of the mass of water-soluble resin (A) and the mass of light absorber (B) in the protective film forming agent is preferably 1% by mass or more and 50% by mass or less, more preferably 5% by mass or more and 40% by mass or less, and even more preferably 10% by mass or more and 40% by mass or less.

### <Other Additives>

The protective film forming agent may contain other compounding agents unless inhibiting the object of the present invention, in addition to the water-soluble resin (A) and light absorber (B). As the other compounding agent, for example, it is possible to use preservatives, surfactants, etc.

As the preservative, it is possible to use benzoic acid, butylparaben, ethylparaben, methylparaben, propylparaben, sodium benzoate, sodium propionate, benzalkonium chloride, benzethonium chloride, benzyl alcohol, cetylpyridinium chloride, chlorobutanol, phenol, phenylethyl alcohol, 2-phenoxyethanol, phenylmercuric nitrate, thimerosal, metacresol, lauryldimethylamine oxide, and combinations of these.

Using a preservative is preferable not only from the point of preservation of the protective film forming agent, but also from the point of a load reduction in the processing of waste liquid after semiconductor wafer washing. A large amount of washing water is generally used for washing of semiconductor wafers. However, in the process using the aforementioned protective film forming agent, proliferation of bacteria in the waste liquid is of concern due to the water-soluble resin (A) contained in the protective film forming agent. For this reason, it is desirable for the waste liquid derived from a process using the aforementioned protective film forming agent to be treated separately from the waste liquid derived from a process not using the protective film forming agent. However, in the case of containing a preservative in the protective film forming agent, since the proliferation of bacteria caused by the water-soluble resin (A) is suppressed, the waste liquid derived from the process using the protective film forming agent and the waste liquid derived from a process not using the protective film forming agent can be treated similarly. For this reason, it is possible to reduce the load of wastewater treatment processing.

The surfactant, for example, is used in order to raise the defoaming property during protective film forming agent production, stability of the protective film forming agent, coatability of the protective film forming agent, etc. In particular, it is preferable to use a surfactant in terms of the defoaming property during protective film forming agent production.

A protective film may be formed by spin coating the protective film forming agent. However, surface irregularities caused by bubbles frequently occur upon forming the protective film by spin coating. In order to suppress the occurrence of such surface irregularities, it is preferable to use an antifoaming agent such as a surfactant.

As the surfactant, a water-soluble surfactant can be used preferably. As the surfactant, any of nonionic surfactant, cationic surfactant, anionic surfactant and amphoteric surfactant can be used. The surfactant may be silicone based. A nonionic surfactant is preferable from the point of washability.

### <Solvent (S)>

The protective film forming agent usually contains a solvent (S) for dissolving the water-soluble resin (A) and light absorber (B). As the solvent (S), it is possible to use any of water, organic solvent, and an aqueous solution of organic solvent. In the point of little risk of ignition during use, cost, etc., water and an aqueous solution of organic solvent are preferable as the solvent (S), and water is more preferable. In addition, from the point of the drying properties of the protective film forming agent during forming the protective film, it is also preferable that the solvent (S) is an organic solvent.

From the viewpoint of flammability, the content of organic solvent in the solvent (S) is preferably 20% by mass or less, more preferably 15% by mass or less, even more preferably 10% by mass or less, yet more preferably 5% by mass or less, and particularly preferably 3% by mass or less.

The solvent (S) is preferably selected so that the protective film forming agent does not have a flash point under 1 atm of pressure. More specifically, by adjusting the content of water in the protective film forming agent, the flash point of the protective film, or presence/absence of a flash point is adjusted. The protective film forming agent without a flash point is safe, for example, and can be left in a non-explosion proof environment. More specifically, it is possible to carry out handling such as storage, transport and use of the protective film forming agent in a non-explosion proof environment. For example, not only the introduction of the protective film forming agent to the semiconductor factory, but also the formation of the protective film can be carried out in a non-explosion proof environment. Therefore, in the point of an explosion proof environment such as a usually expensive explosion proof equipment being unnecessary, the protective film forming agent without a flash point is very advantageous in industry.

The flash point can be obtained by measuring under 1 atm of pressure by the tag closed cup method at a liquid temperature of 80°C or lower, and measured by the Cleveland open cup method at a liquid temperature exceeding 80°C. In the scope of the disclosure and claims of the present application, a case of the flash point not being measurable even when measuring by the Cleveland open cup method is defined as being without a flash point.

As examples of an organic solvent which can be contained in the protective film forming agent, it is possible to exemplify methyl alcohol, ethyl alcohol, alkylene glycol, alkylene glycol monoalkyl ether, alkylene glycol monoalkyl ether acetate and the like. As the alkylene glycol, it is possible to exemplify ethylene glycol, propylene glycol and the like. As the alkylene glycol monoalkyl ether, it is possible to exemplify ethylene glycol monomethyl ether, ethylene glycol monoethyl ether, propylene glycol monomethyl ether, propylene glycol monoethyl ether and the like. As the alkylene glycol monoalkyl ether acetate, it is possible to exemplify ethylene glycol monomethyl ether acetate, ethylene glycol monoethyl ether acetate, propylene glycol monomethyl ether acetate, propylene glycol monoethyl ether acetate and the like. The protective film forming agent may contain a combination of two or more types of organic solvent.

The solid content concentration of the protective film forming agent is not particularly limited in a range not inhibiting the object of the present invention. The solid content concentration, for example, is preferably 5% by mass or more and 60% by mass or less, and more preferably 10% by mass or more and 50% by mass or less.

### <<Production Method of Semiconductor Chips>>

The production method of semiconductor chips is a method including a production of semiconductor chips by processing semiconductor wafers. More specifically, the production method of semiconductor chips is a method including:
forming a protective film by coating the aforementioned protective film forming agent on a semiconductor wafer; and
irradiating a laser beam on a predetermined position of at least one layer containing the protective film on the semiconductor wafer, the surface of the semiconductor wafer being exposed, and forming a processed groove of a pattern according to a shape of the semiconductor chip. Typically, the above-mentioned production method of semiconductor chips includes a cutting step of cutting the position of streets in the semiconductor wafer. Hereinafter, forming a protective film is also noted as "protective film forming step", forming a processed groove is also noted as "processed groove forming step", and cutting the position of a street in the semiconductor wafer is also noted as "cutting step".

### <Protective Film Forming Step>

In the protective film forming step, a protective film is formed by coating the aforementioned protective film forming agent on a semiconductor wafer.

The shape of the processed surface of the semiconductor wafer is not particularly limited so long as being able to conduct the desired processing on the semiconductor wafer. Typically, the processed surface of the semiconductor wafer has several surface irregularities. Then, a recessed part in a region corresponding to a street is formed. In the processed surface of the semiconductor wafer, a plurality of regions corresponding to semiconductor chips is demarcated by the streets. In the points of the removal of protective film by washing after processing being easy, and sufficient durability of the protective film to plasma irradiation in the case of performing plasma irradiation in the cutting step described later, typically, the film thickness of the protective film is preferably 1 µm or more and 100 µm or less, and more preferably 10 µm or more and 100 µm or less. It is more preferably 30 µm or more and 100 µm or less. In the case of irradiating a laser in the processed groove forming step and/or cutting step, the film thickness of the protective film is preferably 0.1 µm or more and 50 µm or less. In the cutting step, in the case of performing cutting by a blade, the film thickness of the protective film is not particularly limited. In the case of performing cutting by a blade, since removal of the protective film by washing after processing is easy, the thickness of the protective film is preferably 0.1 µm or more and 100 µm or less, for example.

Hereinafter, a production method of semiconductor chips which performs dicing processing using the aforementioned protective film forming agent on a semiconductor wafer including a plurality of semiconductor chips demarcated by a lattice of streets will be explained as a preferred mode of a production method of the semiconductor chips, while referencing the drawings.

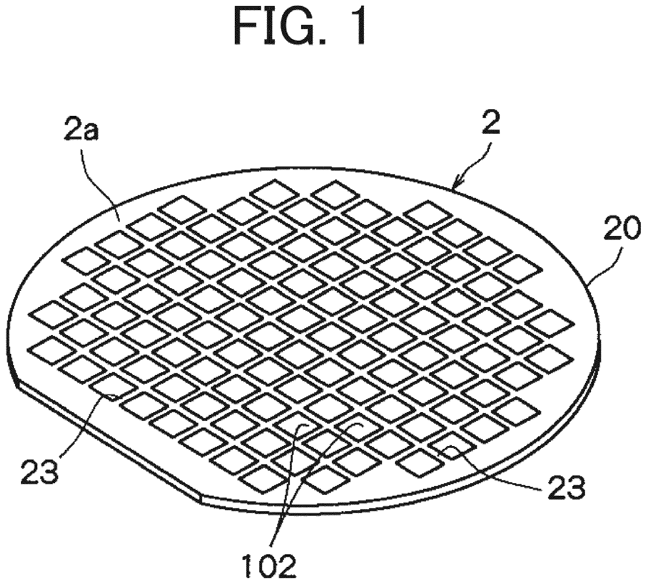

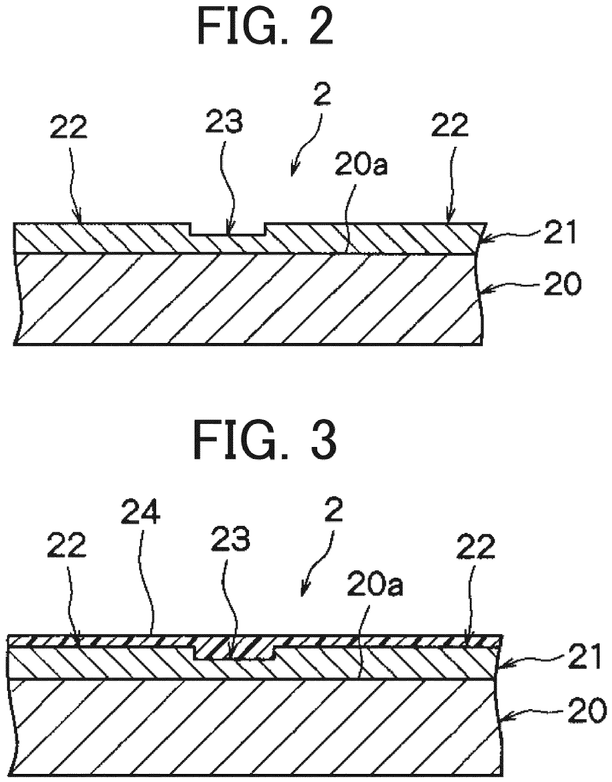

FIG. 1 shows a perspective view of a semiconductor wafer which is a processing target. FIG. 2 shows an enlarged cross-sectional view of the main parts of the semiconductor wafer shown in FIG. 1. With the semiconductor wafer 2 shown in FIGS. 1 and 2, a laminate 21 in which a functional film forming an insulating film and circuit are laminated is provided on a surface 20a of a semiconductor substrate 20 such as silicon. In the laminate 21, a plurality of semiconductor chips 22 such as IC and LSI are formed in a matrix shape. Herein, the shape and size of the semiconductor chips 22 are not particularly limited, and can be appropriately set according to the design of the semiconductor chip 22.

Each of the semiconductor chips 22 is demarcated by the streets 23 formed in a lattice shape. It should be noted that, in the illustrated embodiment, the insulating film used as the laminate 21 consists of a SiO₂ film, or a low-dielectric constant insulating film (Low-k film) consisting of an inorganic film of SiOF, BSG (SiOB) or the like, or an organic film, which is a polymer film such as of polyimide type or parylene type.

The surface of the above-mentioned laminate 21 corresponds to the surface 2a which is the processed surface. The protective film is formed using the aforementioned protective film forming agent on the above-mentioned surface 2a.

In the protective film forming step, for example, the protective film is formed by coating the protective film forming agent on the surface 2a of the semiconductor wafer 2 by spray coating. In the aforementioned protective film forming agent, its viscosity is less likely to be increased excessively even at a high solid content concentration. For this reason, in the case of setting the film thickness of the protective film on the high side, a desired thick protective film can be formed with a lower number of coatings by spray coating of a protective film forming agent with a solid content concentration on the higher side. It should be noted that the coating method of the protective film forming agent is not particular limited so long as being able to form a protective film of the desired film thickness.

Next, the protective film forming agent of liquid form coating the surface 2a is dried. A protective film 24 is thereby formed on the surface 2a of the semiconductor wafer 2 as shown in FIG. 3.

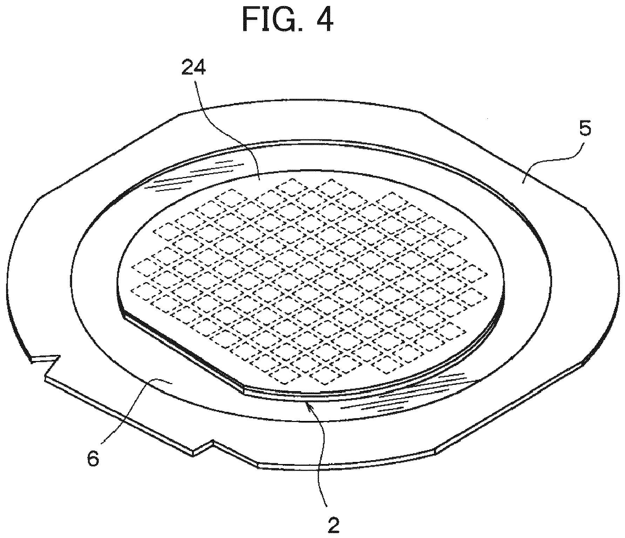

After the protective film 24 is formed on the surface 2a of the semiconductor wafer 2 in this way, protective tape 6 put onto an annular frame 5 is pasted to the back surface of the semiconductor wafer 2, as shown in FIG. 4.

### <Processed Groove Forming Step>

In the processed groove forming step, a laser beam is irradiated onto a predetermined position of at least one layer including the protective film 24 on the semiconductor wafer 2, the surface 20a of the semiconductor substrate 20 being exposed, whereby the processed groove of a pattern according to the shape of the semiconductor chip 22 is formed.

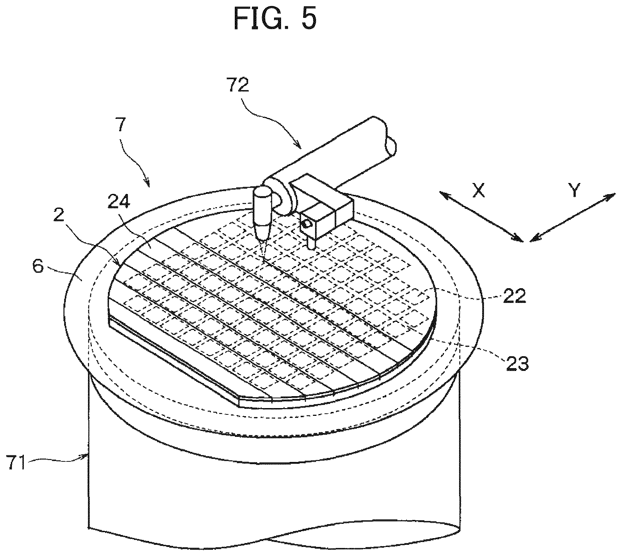

More specifically, a laser beam is irradiated through the protective film 24 to the surface 2a (street 23) of the semiconductor wafer 2. Irradiation of this laser beam is carried out using a laser photoirradiation means 72 as shown in FIG. 5. The laser is preferably an ultraviolet laser having a wavelength of 100 nm or longer and 400 nm or shorter from the point of intensity. In addition, a YVO4 laser and YAG laser having a wavelength of 266 nm, 355 nm, etc. are preferable.

The above-mentioned laser beam irradiation in the processed groove forming step is performed at the following processing conditions, for example. It should be noted that the focus spot diameter is appropriately selected considering the width of the processed groove 25.
Light source of laser beam: YVO4 laser or YAG laser Wavelength: 355 nm
Repetition frequency: 50 kHz or more and 100 kHz or less Output: 0.3 W or more and 4.0 W or less
Process feed rate: 1 mm/s or faster and 800 mm/s or slower

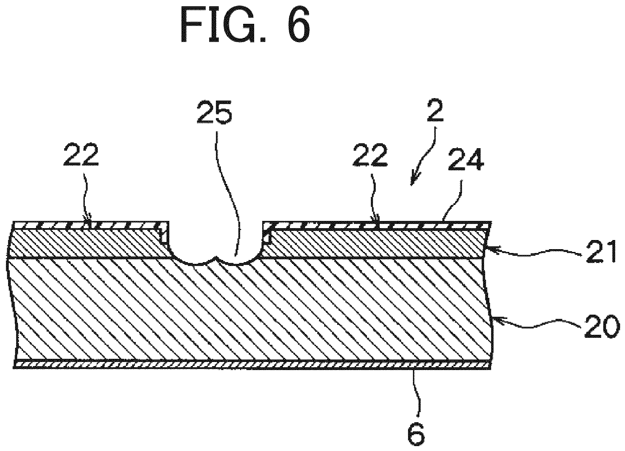

By conducting the aforementioned processed groove forming step, the processed groove 25 is formed along the street 23 in the laminate 21 including the street 23 of the semiconductor wafer 2, as shown in FIG. 6. In the case of the protective film 24 containing the aforementioned compound represented by Formula (B1) as the light absorber (B), by irradiating the laser beam as described above on the protective film 24, it is possible to easily form in the protective film 24 a groove having an opening of the desired shape, and cross-section of a favorable shape which is flat and straight.

If executing irradiation of the laser beam along a predetermined street 23 in the aforementioned way, the semiconductor wafer 2 retained on a chuck table 71 is indexed by intervals of the street in the direction indicated by the arrow Y, and irradiation of the laser beam is carried out again.

After carrying out irradiation of the laser beam and indexing of all of the streets 23 extending in a predetermined direction in this way, the semiconductor wafer 2 retained on the chuck table 71 is rotated by 90 degrees, and the irradiation of the laser beam and indexing is executed as described above along each street 23 extending at a right angle relative to the above-mentioned predetermined direction. In this way, it is possible to form the processed groove 25 along all of the streets 23 formed in the laminate 21 on the semiconductor wafer 2.

### <Cutting Step>

In the cutting step, the semiconductor wafer 2 including the processed groove 25 at a position corresponding to the position of the street 23 is cut. As a preferred method, it is possible to exemplify a method of cutting the semiconductor wafer 2 by irradiating a laser or plasma on the semiconductor wafer 2 including the protective film 24 and processed groove 25, and a method of cutting the semiconductor wafer 2 including the protective film 24 or semiconductor wafer 2 from which the protective film 24 has been peeled, by a blade. In the case of irradiating a laser, the laser is irradiated on the processed groove 25 in order to cut the semiconductor wafer 2. In the case of irradiating plasma, the plasma is irradiated on a part of the surface including the protective film of the semiconductor wafer 2 or the entire surface, so that plasma is exposed to the surface of the processed groove 25. In the case of performing cutting by a blade, the semiconductor wafer 2 is cut by a blade along a position of the processed groove 25, while supplying pure water to the cutting location. Hereinafter, a cutting method by plasma irradiation which is a preferable cutting method will be explained.

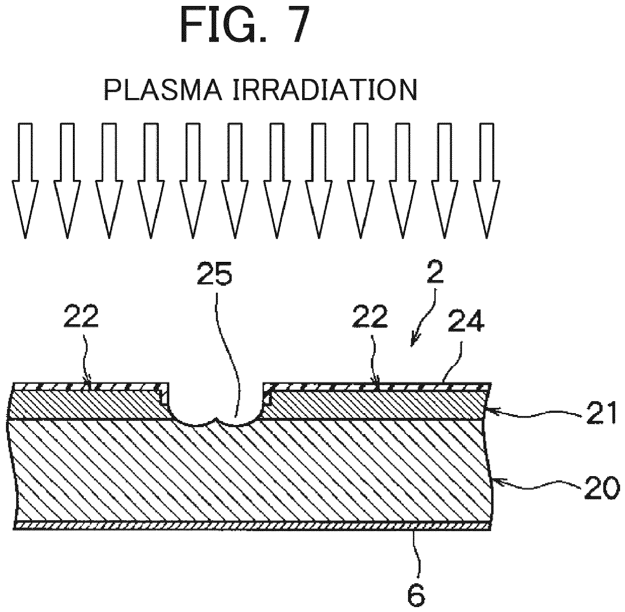

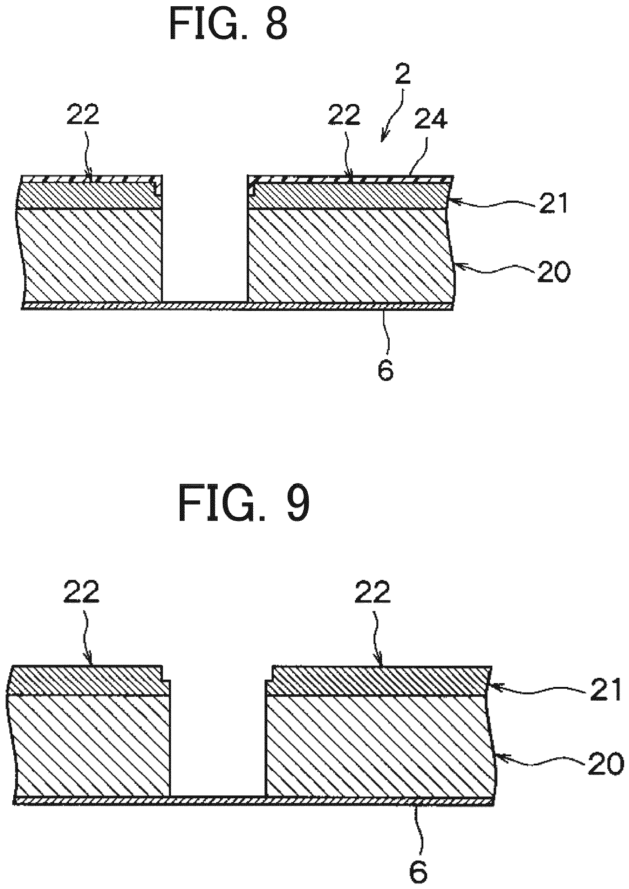

As shown in FIG. 7, plasma is irradiated onto the semiconductor wafer 2 including the protective film 24 and processed groove 25. By configuring in this way, the position of the processed groove 25 in the semiconductor wafer 2 is cut as shown in FIG. 8. More specifically, in the semiconductor wafer 2 coated by the protective film 24, after forming the processed groove 25 as described above, by performing plasma irradiation on the protective film 24 and surface 20a of the semiconductor substrate 20 exposed from the processed groove 25, the semiconductor wafer 2 is cut following the shape of the semiconductor chips 22, and the semiconductor wafer 2 is divided into the semiconductor chips 22.

The plasma irradiation conditions are not particularly limited so long as being able to favorably perform cutting of the semiconductor wafer 2 at the position of the processed groove 25. The plasma irradiation conditions are appropriately set within a range of common conditions of plasma etching on a semiconductor substrate, considering the material of the semiconductor wafer 2, plasma type and the like. The gas used for generating plasma in the plasma irradiation is appropriately selected according to the material of the semiconductor wafer 2. Typically, SF₆ gas is used in the generation of the plasma. In addition, by alternately performing sidewall protection by the supply of C₄F₆ or C₄F₈ gas, and etching of the semiconductor wafer 2 by plasma irradiation in accordance with the so-called BOSCH process, cutting of the semiconductor wafer 2 may be performed. According to the BOSCH process, etching with a high-aspect ratio is possible, and even in a case of the semiconductor wafer 2 being thick, cutting of the semiconductor wafer 2 is easy.

Next, as shown in FIG. 9, the protective film 24 covering the surface of the semiconductor chip 22 is removed. As mentioned above, the protective film 24 is formed using the protective film forming agent containing the water-soluble resin (A); therefore, it is possible to wash away the protective film 24 using water (or hot water).

A production method of semiconductor chips by processing a semiconductor wafer has been explained above based on the embodiment. The protective film forming agent and production method of semiconductor chips according to the present invention can be applied to production methods of various semiconductor chips, so long as being a method including the forming of a protective film on the semiconductor wafer surface, and forming a processed groove at a position corresponding to the street in the surface including the protective film of the semiconductor wafer.

### EXAMPLES

Hereinafter, the present invention will be explained in detail by way of Examples and Comparative Examples. The present invention is in no way limited to the following Examples.

### [Example 1]

A monomer (4-acryloylmorpholine) represented by the following formula, a chain transfer agent (thioglycerol) in an amount of 1 mol% relative to the sum of the number of moles of the monomer and the number of moles of the chain transfer agent, and a polymerization initiator (V-601HP, FUJIFILM Wako Pure Chemical Corporation, Co. Ltd.) in an amount of 5 mol% relative to the sum of the number of moles of the monomer and the number of moles of the chain transfer agent were dissolved in propylene glycol monomethyl ether so that the total of the concentrations of the monomer, the chain transfer agent and the polymerization initiator was 30% by mass. The solution obtained thus was stirred, and polymerization was performed at 80°C for 120 minutes. The weight average molecular weight of the polymer obtained thus was 9,100.

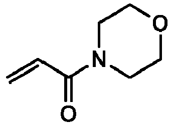

In addition, the viscosity of a 30% by mass solution of the polymer obtained thus was measured at 25°C using a rotational viscometer (E-type; cone and plate type). The viscosity of the solution obtained thus was 100 cp or less.

### [Example 2]

9 parts by mass of the polymer obtained in Example 1, 1 part by mass of light absorber (B) having the following structure (2-hydroxy-4-diethylamino-2'-carboxybenzophenone), and 0.25 parts by mass of monoethanolamine were dissolved in 23.9 parts by mass of propylene glycol monomethyl ether, to obtain a protective film forming agent having a solid content concentration of 30% by mass.

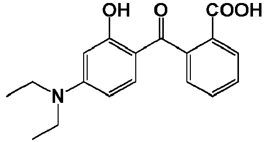

When coating of the protective film forming agent obtained thus onto a silicon wafer by spray coating was tried, the spray coating was possible, and a protective film having a film thickness of 30 µm could be formed by applying the coating five times. For the protective film formed thus, the occurrence of cracks was determined through an optical micrograph immediately after the formation and after subjecting it to a vacuum condition of 40 Pa for 1 minute. The result was that there was no occurrence of cracks immediately after the formation of the protective film, and an extremely slight occurrence of cracks was observed after subjecting it to the vacuum condition. Next, a laser was irradiated linearly on a protective-film-side surface of the silicon substrate having the protective film under the following conditions, and a cross-sectional shape of the laser-irradiated portion of the protective film was observed with an electron microscope. As a result, it was found that a groove having a favorable shape could be formed by the laser irradiation without any problem.

### <Laser Irradiation Conditions>

Wavelength: 355 nm
Frequency: 100 kHz
Output: 0.3 W
Defocus: -0.5 mm
Feed rate: 100 mm/s
Pass: 3

### [Example 3]

A copolymer of 4-acryloylmorpholine and 2-(2-ethoxyethoxy)ethyl acrylate was obtained in the same manner as Example 1 except that the composition of the monomer and the chain transfer agent in the polymerization reaction solution was changed to 82 mol% of the aforementioned 4-acryloylmorpholine, 17 mol% of 2-(2-ethoxyethoxy)ethyl acrylate, and 1 mol% of the chain transfer agent. The weight average molecular weight of the copolymer obtained thus was 11,400. The viscosity of a 30% by mass solution of the copolymer obtained thus was measured at 25°C using a rotational viscometer (E-type; cone and plate type). The viscosity of the solution obtained thus was 100 cp or less.

### [Example 4]

A protective film forming agent was obtained in the same manner as Example 2 except that the polymer was changed to the copolymer obtained in Example 3. When coating of the protective film forming agent obtained thus onto a silicon wafer by spray coating was tried, the spray coating was possible, and a protective film having a film thickness of 30 µm could be formed by applying the coating five times. For the protective film formed thus, the occurrence of cracks was determined through an optical micrograph immediately after the formation and after subjecting it to a vacuum condition of 40 Pa for 1 minute. The result was that there was no occurrence of cracks both immediately after the formation of the protective film and after subjecting it to the vacuum condition. Next, a laser was irradiated linearly on a protective-film-side surface of the silicon substrate having the protective film in the same manner as Example 2, and a cross-sectional shape of the laser-irradiated portion of the protective film was observed with an electron microscope. As a result, it was found that a groove having a favorable shape could be formed by the laser irradiation without any problem.

### [Example 5]

A copolymer of 4-acryloylmorpholine and 2-hydroxyethyl methacrylate was obtained in the same manner as Example 3 except that the composition of the monomer and the chain transfer agent in the polymerization reaction solution was changed to 82 mol% of the aforementioned 4-acryloylmorpholine, 17 mol% of 2-hydroxyethyl methacrylate, and 1 mol% of the chain transfer agent. The weight average molecular weight of the copolymer obtained thus was 13,700. The viscosity of a 30% by mass solution of the copolymer obtained thus was measured at 25°C using a rotational viscometer (E-type; cone and plate type). The viscosity of the solution obtained thus was 100 cp or less.

### [Example 6]

A protective film forming agent was obtained in the same manner as Example 2 except that the polymer was changed to the copolymer obtained in Example 4. When coating of the protective film forming agent obtained thus onto a silicon wafer by spray coating was tried, the spray coating was possible, and a protective film having a film thickness of 30 µm could be formed by applying the coating five times. For the protective film formed thus, the occurrence of cracks was determined through an optical micrograph immediately after the formation and after subjecting it to a vacuum condition of 40 Pa for 1 minute. The result was that there was no occurrence of cracks both immediately after the formation of the protective film and after subjecting it to the vacuum condition. Next, a laser was irradiated linearly on a protective-film-side surface of the silicon substrate having the protective film in the same manner as Example 2, and a cross-sectional shape of the laser-irradiated portion of the protective film was observed with an electron microscope. As a result, it was found that a groove having a favorable shape could be formed by the laser irradiation without any problem.

### [Example 7]

A copolymer of 4-acryloylmorpholine and 2-(2-ethoxyethoxy)ethyl acrylate was obtained in the same manner as Example 3 except that propylene glycol monomethyl ether was changed to a mixed solvent containing 50% by mass of propylene glycol monomethyl ether and 50% by mass of isopropanol. The weight average molecular weight of the copolymer obtained thus was 8,300. The viscosity of a 30% by mass solution of the copolymer obtained thus was measured at 25°C using a rotational viscometer (E-type; cone and plate type). The viscosity of the solution obtained thus was 100 cp or less.

### [Example 8]

A protective film forming agent was obtained in the same manner as Example 2 except that the polymer was changed to the copolymer obtained in Example 7. When coating of the protective film forming agent obtained thus onto a silicon wafer by spray coating was tried, the spray coating was possible, and a protective film having a film thickness of 30 µm could be formed by applying the coating five times. For the protective film formed thus, the occurrence of cracks was determined through an optical micrograph immediately after the formation and after subjecting it to a vacuum condition of 40 Pa for 1 minute. The result was that there was no occurrence of cracks immediately after the formation of the protective film, and an extremely slight occurrence of cracks was observed after subjecting it to the vacuum condition. Next, a laser was irradiated linearly on a protective-film-side surface of the silicon substrate having the protective film in the same manner as Example 2, and a cross-sectional shape of the laser-irradiated portion of the protective film was observed with an electron microscope. As a result, it was found that a groove having a favorable shape could be formed by the laser irradiation without any problem.

### [Comparative Example 1]

A protective film forming agent was obtained in the same manner as Example 2 except that the polymer was changed to hydroxypropyl cellulose having a weight average molecular weight of 40,000. Coating of the protective film forming agent obtained thus on a silicon wafer by spray coating was impossible.

In addition, the viscosity of a solution obtained by dissolving the hydroxypropyl cellulose having a weight average molecular weight of 40,000 in propylene glycol monomethyl ether so that the solid content concentration was 30% by mass was measured at 25°C using a rotational viscometer (E-type; cone and plate type). The viscosity of the solution obtained thus was more than 100 cp.

### [Comparative Example 2]

A protective film forming agent having a solid content concentration of 10% by mass was obtained by dissolving 9 parts by mass of hydroxypropyl cellulose having a weight average molecular weight of 40,000, 1 part by mass of light absorber (B) (2-hydroxy-4-diethylamino-2'-carboxybenzophenone), and 0.25 parts by mass of monoethanolamine in 92.25 parts by mass of water.

In addition, the viscosity of a solution obtained by dissolving the hydroxypropyl cellulose having a weight average molecular weight of 40,000 in water so that the solid content concentration was 10% by mass was measured at 25°C using a rotational viscometer (E-type; cone and plate type). The viscosity of the solution obtained thus was 100 cp or less.

The protective film forming agent having a solid content concentration of 10% by mass was used to coat the protective film forming agent onto a silicon wafer by spray coating in the same manner as Example 2, and applying the coating fifteen times was needed to form a protective film having a film thickness of 30 µm. EXPLANATION OF REFERENCE NUMERALS
- 2: semiconductor wafer
- 20: substrate
- 21: laminate
- 22: semiconductor chip
- 23: street
- 24: protective film
- 25: laser processed groove
- 26: cut groove
- 5: annular frame
- 6: protective tape
- 7: laser processing device
- 71: chuck table of laser processing device
- 72: laser beam irradiation means

## Claims

1. A protective film forming agent to be used for forming a protective film on a surface of a semiconductor wafer in dicing of the semiconductor wafer, the protective film forming agent comprising:
a water-soluble resin (A); a light absorber (B) and a solvent (S),
wherein the water-soluble resin (A) comprises a (meth)acrylic resin comprising a structural unit derived from a (meth)acrylamide derivative represented by Formula (a1) below, 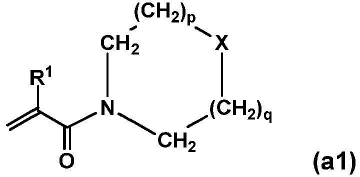
wherein R¹ is a hydrogen atom or a methyl group, X is a methylene group, -O-, -S-, or -NR²-, R² is a hydrogen atom or an alkyl group having 1 or more and 4 or less carbon atoms, p and q are each independently an integer of 0 or more and 6 or less, and a sum of p and q is 1 or more and 6 or less.

2. The protective film forming agent according to claim 1, wherein p is 1, and q is 1.

3. The protective film forming agent according to claim 1 or 2, wherein X is -O-.

4. The protective film forming agent according to any one of claims 1 to 3, wherein a ratio of the structural unit derived from the (meth)acrylamide derivative represented by Formula (a1) relative to total structural units in the (meth)acrylic resin is 70 mol% or more and 98 mol% or less.

5. The protective film forming agent according to any one of claims 1 to 4, wherein the (meth)acrylic resin comprises the structural unit derived from the (meth)acrylamide derivative represented by Formula (a1), and a structural unit derived from the (meth)acrylic acid ester represented by Formula (a2) below,
CH₂=CR¹-CO-O-(-R³-O-)ᵣ-R⁴ ... (a2)
wherein R¹ is a hydrogen atom or a methyl group, R³ is an alkylene group having 1 or more and 4 or less carbon atoms, R⁴ is a hydrogen atom or an alkyl group having 1 or more and 4 or less carbon atoms, r is an integer of 1 or more and 6 or less, wherein in a case where r is an integer of 2 or more and 6 or less, a plurality of R³ groups are identical to or different from one another.

6. The protective film forming agent according to claim 5, wherein a ratio of the structural unit derived from the (meth)acrylic acid ester represented by Formula (a2) relative to total structural units in the (meth)acrylic resin is 8 mol% or more and 20 mol% or less.

7. A method for producing a semiconductor chip by processing a semiconductor wafer, the method comprising the steps of:
forming a protective film by coating the protective film forming agent according to any one of claims 1 to 6 on the semiconductor wafer; and
irradiating a laser beam on a predetermined position of at least one layer containing the protective film on the semiconductor wafer, a surface of the semiconductor wafer being exposed, and then forming a processed groove of a pattern according to a shape of the semiconductor chip.

8. The method for producing a semiconductor chip according to claim 7, wherein the protective film is formed by spray coating the protective film forming agent.

9. A method for producing a (meth)acrylic resin, the method comprising the step of:
polymerizing a monomer comprising a (meth)acrylamide derivative represented by Formula (a1) below in presence of one or more selected from the group consisting of alkylene glycol monoalkyl ether, alkylene glycol monoacetate, and alkylene glycol monoalkyl ether monoacetate, 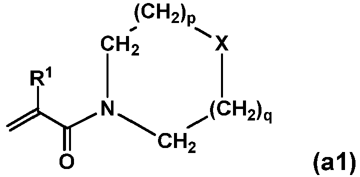 wherein R¹ is a hydrogen atom or a methyl group, X is a methylene group, -O-, -S-, or -NR²-, R² is a hydrogen atom or an alkyl group having 1 or more and 4 or less carbon atoms, p and q are each independently an integer of 0 or more and 6 or less, and a sum of p and q is 1 or more and 6 or less.
